# FASCICULE DE BREVET EUROPEEN

(11) **EP 1 467 607 B1**
(45) Date de publication et mention de la délivrance du brevet: **22.08.2007**
(21) Numéro de dépôt: 04101448.1
(22) Date de dépôt: 07.04.2004
(51) Int. Cl.: H05K 7/20, H05K 7/14, H02M 7/00, H01L 23/473

(54) **Module de commutation de puissance et onduleur équipé de ce module**
Leistungsschaltermodul und Wechselrichter mit einem solchen Modul
Power switch module and inverter with such a module

(30) Priorité: 09.04.2003 FR 0304407
(43) Date de publication de la demande: 13.10.2004
(73) Titulaire: Alstom, 92300 Levallois-Perret (FR)
(72) Inventeur: MARTIN, Nathalie, 65000, TARBES (FR); BOURSAT, Benoit, 64320, BIZANOS (FR); DUTARDE, Emmanuel, 64800, MIREPEIX (FR); SAIZ, José, 65800, AUREILHAN (FR); CETTOUR-ROSE, Jacques, 65200, ORDIZAN (FR); SOLOMALALA, Pierre, 65800, AUREILHAN (FR)
(74) Mandataire: Domenego, Bertrand

(56) Documents cités:
- EP-A- 0 901 166
- FR-A- 2 765 067
- FR-A- 2 775 416
- GB-A- 1 416 561

## Description

L'invention concerne un module de commutation de puissance et un onduleur polyphasé équipé de ce module.

Plus précisément, l'invention concerne un module de commutation de puissance comportant :
- au moins un commutateur de puissance au-dessus d'au moins un autre commutateur de puissance, le ou chaque commutateur du dessus comportant une paroi supérieure, et le ou chaque commutateur du dessous comportant une paroi inférieure, ces parois inférieure et supérieure étant aptes à être refroidies par conduction thermique avec un fluide de refroidissement,
- des canaux fermés inférieurs et supérieurs configurés pour faire circuler le fluide de refroidissement le long respectivement des parois inférieure et supérieure des commutateurs du dessous et du dessus.

De tels modules de puissance sont par exemple utilisés dans les onduleurs de puissance triphasée alimentant des moteurs de machines électriques, tels que les moteurs de traction d'un train.

Classiquement, de tels onduleurs de puissance comportent deux interrupteurs par phase.

Les courants à commuter étant relativement importants, c'est-à-dire par exemple, de l'ordre de quelques milliers d'ampères, chaque interrupteur est en réalité formé de plusieurs commutateurs de puissance, eux-mêmes formés chacun d'une multitude d'interrupteurs élémentaires, tels que, par exemple, des transistors IGBT (*Insulated Gate Bipolar Transistor*)*.* Du fait de la présence de cette multitude de transistors, ces interrupteurs de puissance sont d'une part, volumineux et, d'autre part, doivent être refroidis pour éviter un échauffement excessif.

A cet effet, il est connu de former un module de commutation dans lequel les deux interrupteurs d'une même phase sont disposés l'un au-dessus de l'autre, de manière à réduire l'encombrement de ce module. Dans ce mode de réalisation connu, un circuit de refroidissement est ménagé uniquement sur les surfaces extérieures de chacun des interrupteurs du module, de manière à évacuer la chaleur générée par les transistors. Bien que ce module, comportant deux interrupteurs l'un au-dessus de l'autre, soit moins encombrant que ceux utilisés jusqu'à présent, son encombrement reste, toutefois, important.

Ainsi, l'invention vise à réduire encore plus l'encombrement d'un module de commutation de puissance comportant au moins deux interrupteurs de puissance placés l'un au-dessus de l'autre.

Il est par ailleurs connu du document de brevet FR 2 169 093 A1 un arrangement modulaire de composants semi-conducteurs de puissance, dans lequel des éléments semi-conducteurs sont disposés dans des boîtiers en forme de disque. Un liquide de refroidissement peut circuler dans un espace comprenant des moyens élastiques entre deux boîtiers superposés. Ce liquide permet le refroidissement de la paroi inférieure du boîtier du dessus et de la paroi supérieure du boîtier du dessous. En outre, les parois externes de cet arrangement modulaire sont aussi refroidies par un liquide de refroidissement qui circule le long du module. Il est donc connu de refroidir un module de commutation de puissance par une double circulation de liquide de refroidissement d'une part le long des parois externes du module et d'autre part à l'intérieur même du module. Toutefois, dans l'arrangement modulaire décrit par ce document de brevet, les moyens élastiques dans l'espace entre deux boîtiers superposés gênent l'écoulement du liquide de refroidissement le long des faces des boîtiers internes au module, et l'échange thermique est donc d'une efficacité limitée. L'encombrement de ce module reste ainsi important par rapport à la quantité de courant que peut commuter le module. Une relativement grande quantité de liquide de refroidissement est nécessaire pour dissiper la chaleur par les faces intérieures des composants.

Les enseignements de ce document ne permettent donc pas, à partir d'un module de commutation connu dans lequel un circuit de refroidissement est ménagé uniquement sur les surfaces extérieures de chacun des interrupteurs du module, de modifier un tel module pour en réduire encore plus l'encombrement comme visé dans l'invention.

L'invention a donc pour objet un module de commutation de puissance comportant :
- au moins un commutateur de puissance au-dessus d'au moins un autre commutateur de puissance, chaque commutateur de puissance comportant deux parois respectivement supérieure et inférieure, ces deux parois étant aptes à être refroidies chacune par conduction thermique avec un fluide de refroidissement,
- deux supports sur lesquels sont fixées respectivement les parois inférieures et supérieures des commutateurs du dessous et du dessus
- des canaux fermés inférieurs et supérieurs ménagés respectivement dans les supports et configurés pour faire circuler un fluide de refroidissement le long respectivement des parois inférieures et supérieures des commutateurs du dessous et du dessus,
caractérisé en ce qu'il comporte une cale logée entre le ou les commutateurs du dessus et le ou les commutateurs du dessous de manière à maintenir entre eux une distance prédéterminée dans laquelle sont ménagés, un évidement inférieur le long et au dessus de la paroi supérieure du ou de chaque commutateur du dessous ainsi qu'un évidement supérieur le long et au dessous de la paroi inférieure du ou de chaque commutateur du dessus pour refroidir ces parois en faisant circuler un fluide de refroidissement dans chaque évidement inférieur et supérieur.

Dans le module ci-dessus, les commutateurs de puissance sont refroidis chacun par dessus et par dessous. Dès lors, la chaleur créée par les pertes par commutation des transistors est évacuée par l'intermédiaire de deux parois. Le fluide de refroidissement circule sans entrave dans chaque évidement inférieur et supérieur, et le refroidissement des transistors est donc plus performant que ce qui est réalisé dans l'état de la technique. Par ailleurs, la quantité de courant que peut commuter un transistor est principalement limitée par sa capacité à dissiper la chaleur. En particulier, lorsqu'un transistor est refroidi, il a été constaté qu'il est possible de faire commuter à ce transistor des courants jusqu'à cinq fois supérieurs à la valeur nominale prévue pour ce transistor. Ainsi, à caractéristiques électriques égales, l'interrupteur de puissance qui est formé par les commutateurs de puissance utilisés dans le module ci-dessus présente moins de transistors qu'un interrupteur de puissance de l'état de la technique refroidi uniquement par une seule paroi. Puisque le nombre de transistors dans chaque commutateur d'un interrupteur de puissance est réduit, l'encombrement de chaque interrupteur est également réduit. Il a été constaté que cette diminution de la taille de chaque interrupteur contrebalançait largement l'augmentation de la taille du module de commutation due à la présence de parois supplémentaires et d'un second circuit de circulation d'un fluide de refroidissement. Par conséquent, un module de commutation selon l'invention équipé de deux circuits de refroidissement présente finalement un encombrement inférieur à celui d'un module de commutation connu ne présentant qu'un seul circuit de refroidissement.

Suivant d'autres caractéristiques du module de commutation conforme à l'invention, celui-ci se caractérise en ce que :
- les évidements inférieur et supérieur possèdent deux extrémités raccordées entre elles pour former un seul circuit de circulation de fluide de refroidissement ;
- le ou chaque commutateur comporte un seul radiateur thermiquement raccordé à l'une de ces parois inférieure ou supérieure, ce radiateur étant équipé d'ailettes en contact direct avec le liquide de refroidissement circulant dans les canaux ou les évidements ;
- seule la paroi supérieure du ou de chaque commutateur du dessus comporte un radiateur, et seule la paroi inférieure du ou de chaque commutateur du dessous comporte un radiateur ;
- les ailettes des radiateurs sont parallèles à la direction principale de circulation du fluide de refroidissement ;
- les canaux inférieur et supérieur sont raccordés l'un à l'autre pour former un seul second circuit de circulation de fluide de refroidissement le long de la paroi supérieure du ou de chaque commutateur du dessus et le long de la paroi inférieure du ou de chaque commutateur du dessous ;
- le ou chaque circuit de circulation du fluide de refroidissement est raccordé à une même pompe apte à faire circuler le fluide de refroidissement dans le ou chaque circuit de circulation ;
- au moins les extrémités d'un évidement et d'un canal sont raccordées à une embouchure commune d'entrée ou de sortie de fluide de refroidissement ;
- la cale est de forme sensiblement parallélépipédique comporte un logement pour chacun des commutateurs ;
- la forme de la cale est adaptée pour venir sceller hermétiquement la surface ouverte des canaux inférieurs et supérieurs ;
- chaque commutateur comporte plusieurs transistors, et des pistes électriques sur lesquelles l'émetteur et/ou la grille de chaque transistor est soudé, ces pistes étant réalisées sur une surface intérieure de la paroi refroidie par le fluide de refroidissement qui circule dans l'évidement ;
- chaque commutateur comporte en plus des pistes électriques sur lesquelles le collecteur de chaque transistor est soudé, ces pistes étant réalisées sur une surface intérieure de la paroi refroidie par le fluide de refroidissement qui circule dans un canal ;
- les transistors sont raccordés électriquement aux pistes électriques par l'intermédiaire de cylindres de soudure fondus.

L'invention a également pour objet un onduleur polyphasé dans lequel chaque phase comporte deux interrupteurs formés chacun d'au moins un commutateur, caractérisé en ce que les deux interrupteurs d'une même phase sont réalisés à l'aide d'un seul module de commutation de puissance conforme à un module selon l'invention.

L'invention sera mieux comprise à la lecture de la description qui va suivre donnée uniquement à titre d'exemple et faite en se référant aux dessins sur lesquels :
- la figure 1 est un schéma électrique d'un onduleur de puissance comportant plusieurs interrupteurs,
- la figure 2 est un schéma électrique partiel d'un des interrupteurs de l'onduleur de la figure 1,
- la figure 3 est une vue éclatée d'un commutateur utilisé pour réaliser l'un des interrupteurs de l'onduleur de la figure 1,
- les figures 4 et 5 sont respectivement des vues en coupe selon la ligne IV de la figure 5 et selon la ligne V de la figure 4 d'un interrupteur de l'onduleur de la figure 1, et
- les figures 6 et 7 sont respectivement des vues en coupe selon la ligne VI de la figure 7 et selon la ligne VII de la figure 6 d'un module de commutation conforme à l'invention.

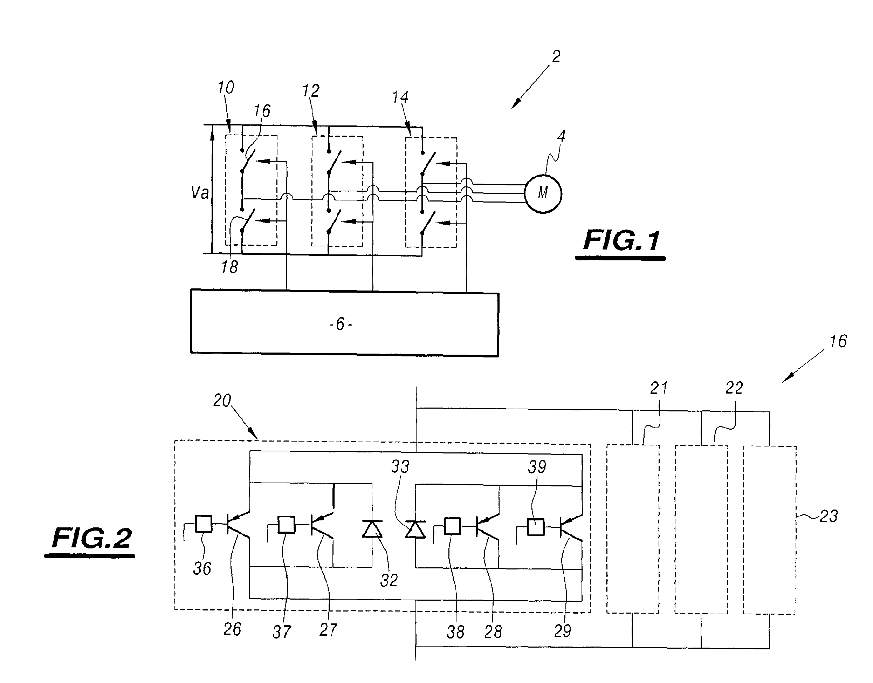

La figure 1 représente un onduleur triphasé de puissance 2 destiné à alimenter une machine électrique tournante 4, tel qu'un moteur, sous la commande d'un calculateur électronique 6.

Le moteur 4 est, par exemple, un des moteurs de traction d'un train.

Le calculateur 6 et les procédés de commande d'un onduleur triphasé sont connus. Ils ne seront donc pas décrits en détail ici.

Le schéma électrique de l'onduleur 2 est classique. Il se compose de trois phases électriques identiques, 10, 12 et 14 formées chacune de deux interrupteurs de puissance identiques 16 et 18. Chaque interrupteur de puissance est ici destiné à commuter des courants de plusieurs milliers d'ampères et apte à résister à des différences de potentiel de plusieurs milliers de volts.

A cet effet, chaque interrupteur est formé à partir de plusieurs commutateurs électriques raccordés en parallèle.

La figure 2 représente, par exemple, un interrupteur formé de quatre commutateurs identiques 20 à 23. Seul le commutateur 20 est représenté en détail.

Ici, à titre d'exemple, chaque commutateur se compose de quatre transistors IGBT 26 à 29, raccordés en parallèle et de deux diodes 32, 33, raccordées en position antiparallèle aux bornes de ces transistors.

Chaque transistor est, par exemple, capable de supporter une tension de 3 000 volts et un courant nominal maximal de 150 ampères. Le fait de raccorder en parallèle les transistors permet donc de réaliser un commutateur capable de commuter un courant beaucoup plus important que celui supporté par chacun des transistors qui le constituent.

La grille de chacun des transistors 26 à 29 est raccordée par l'intermédiaire d'une résistance respective 36 à 39 à une électrode de commande de grille non représentée.

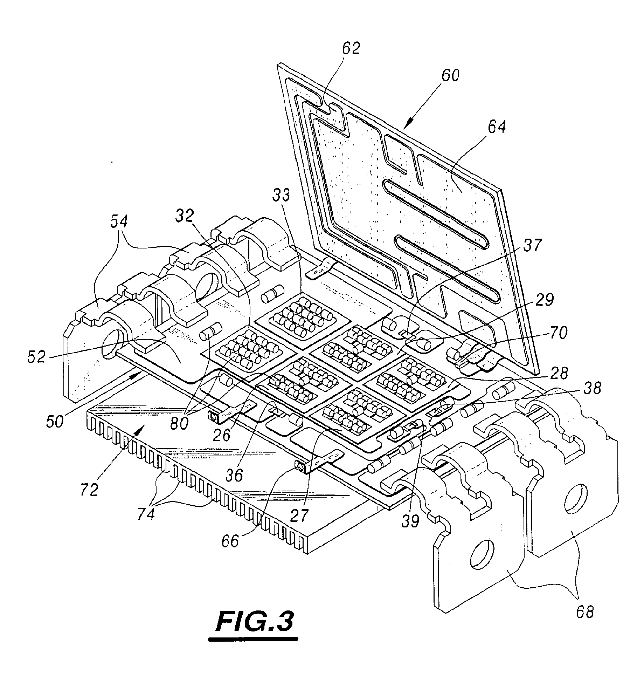

La figure 3 représente dans une vue en perspective la structure éclatée du commutateur 20. Le commutateur comporte un substrat ou paroi inférieur 50, formé dans un matériau électriquement isolant et thermiquement conducteur, tel qu'un matériau diélectrique. Le substrat 50 est sensiblement rectangulaire et disposé à l'horizontale.

Sur une surface intérieure du substrat 50 tournée vers le haut, sont gravées des pistes électriques 52 raccordant les collecteurs des transistors 26 à 29 à des électrodes de collecteur 54. Ces électrodes de collecteur 54 sont soudées aux pistes 52 et font saillie vers l'extérieur sur le petit côté arrière du substrat 50.

Chaque transistor comporte deux faces planes opposées. Ici, sur la figure 3, la face inférieure de chaque transistor porte les électrodes de collecteur du transistor, tandis que la face supérieure porte les électrodes de grille et d'émetteur de ce même transistor.

Le collecteur de chacun des transistors 26 à 29 et la cathode des diodes 32 et 33 sont raccordés par brasage aux pistes 52. Le brasage permet, en plus du raccordement électrique d'assurer le raccordement thermique du collecteur des transistors au substrat 50. Pour assurer un bon transfert de chaleur entre le collecteur de chaque transistor et le substrat 50, la surface de brasage est choisie la plus grande possible.

Le commutateur 20 comporte également un substrat ou paroi supérieur rectangulaire 60, formé dans un matériau électriquement isolant et thermiquement conducteur. Sur la face intérieure de ce substrat 60 tournée vers le substrat 50, sont également gravées des pistes électriques 62, 64. La piste 62 est destinée à raccorder les grilles des transistors 26 à 29 à une électrode de grille 66 par l'intermédiaire des résistances 36 à 39. La piste 64 est destinée à raccorder les émetteurs des transistors 26 à 29 à des électrodes d'émetteur 68.

Ici, les électrodes de grilles et d'émetteurs 66, 68 sont fixées sur le substrat 50.

Finalement, le commutateur 20 comporte également un capteur de température 70 et un radiateur 72.

Le capteur de température 70 est fixé sur la surface intérieure du substrat 50.

Le radiateur 72 est un radiateur en cuivre comportant une multitude d'ailettes 74 parallèles les unes aux autres. L'espace entre deux ailettes consécutives 74 forme petit canal fin de section transversale sensiblement rectangulaire, ayant, par exemple, une profondeur de 3 millimètres et une largeur de 1 millimètre. Le radiateur 72 est fixé par brasage sur la surface extérieure du substrat 50, de manière à ce que les ailettes 74 soient parallèles au petit côté du substrat 50.

Le substrat 60 est fixé parallèlement au substrat 50 et au dessus de celui-ci à l'aide d'un procédé de soudure par cylindres de soudure, connu sous le terme de Procédé de Soudure *"Bumps".* A cet effet, des cylindres de soudure 80 sont disposés sur les différentes surfaces à raccorder électriquement et thermiquement aux pistes 62 et 64 du substrat 60. Ici, ces cylindres 80 sont disposés en particulier sur la surface d'anode des diodes 32 et 33, et sur les surfaces des émetteurs et des grilles des transistors 26 à 29. D'autres cylindres 80 sont également placés de manière à raccorder les électrodes de grille 66 et d'émetteur 68 aux pistes 62 et 64.

Lors de l'assemblage du substrat 60 sur le substrat 50, ces cylindres 80 sont fondus de manière à raccorder électriquement, thermiquement et mécaniquement le substrat 60 au substrat 50. De plus, grâce à l'utilisation de ces cylindres 80, la surface de contact entre les pistes 62, 64 et les surfaces correspondantes des émetteurs et des grilles des transistors est importante et permet également d'assurer un bon transfert de la chaleur entre ces surfaces brasées.

Seul un radiateur 72 est fixé du côté collecteur des transistors car il a été constaté que la quantité de chaleur susceptible d'être évacuée par le substrat auquel sont brasés les collecteurs est nettement supérieure à celle susceptible d'être évacuée par le substrat auquel sont raccordés les émetteurs et les grilles.

Une fois que le substrat 60 a été soudé au substrat 50, l'espace entre ces deux substrats est rempli à l'aide d'un gel diélectrique de manière à isoler les composants électriques de l'environnement extérieur.

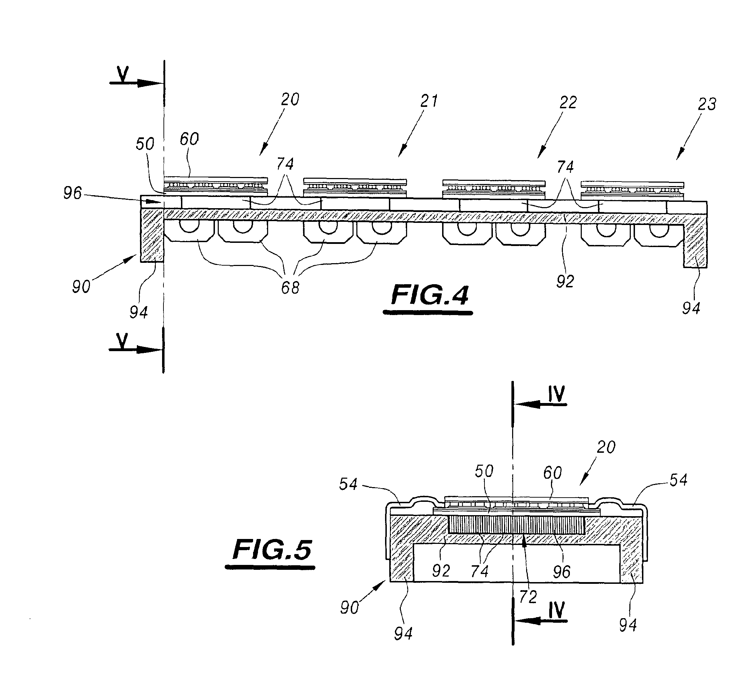

Les figures 4 et 5 représentent schématiquement la structure de l'interrupteur 18. Celui-ci comporte un support inférieur 90 en matériau électriquement isolant tel que du plastique disposé à l'horizontal.

Ce support 90 est, par exemple, formé d'un plateau parallélépipédique horizontal 92 supporté par quatre pieds d'angles verticaux 94.

Sur la surface supérieure de ce plateau 92, est ménagé un canal ouvert 96 de section rectangulaire et s'étendant parallèlement au plus grand côté du plateau 92. Ce canal 96 est destiné à recevoir un liquide de refroidissement ainsi que les radiateurs 72 des commutateurs. A cet effet, la largeur et la profondeur du canal sont adaptées à la largeur et à la hauteur du radiateur 72. En particulier, la profondeur est choisie de manière à ce que l'extrémité libre inférieure de chaque ailette 74 soit en contact avec le fond du canal 96 de manière à définir entre chaque ailette 74 un mini-canal de circulation du liquide de refroidissement. Une telle configuration améliore l'efficacité des ailettes 74.

Les quatre commutateurs 20 à 23 formant l'interrupteur 18 sont emboîtés dans le support 90, de manière à ce que leurs radiateurs 72 respectifs soient logés dans le canal 96. Ici, les commutateurs 20 à 23 sont disposés de manière à ce que les ailettes 74 des radiateurs soient parallèles au plus grand côté du support 90. Cette configuration permet de faciliter l'écoulement du liquide de refroidissement dans le canal 96. Ici, les substrats 50 des commutateurs 20 à 23 sont donc alignés les uns derrière les autres dans un même plan parallèle à la surface supérieure du plateau 92. La surface inférieure des substrats 50 est, par exemple, fixée par collage étanche aux bords du canal 96.

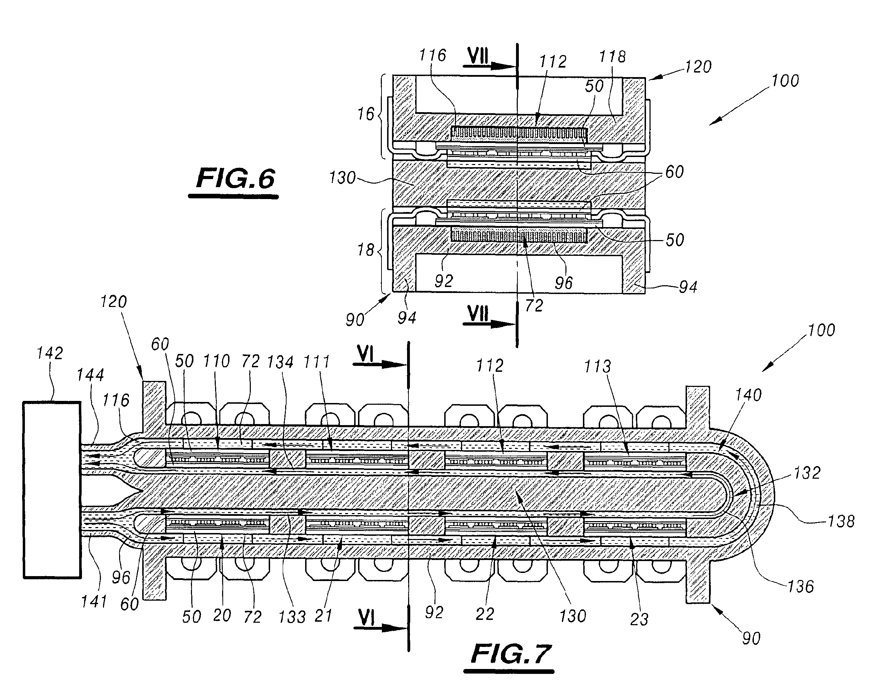

Les figures 6 et 7 représentent schématiquement la structure d'un module de commutation 100 assemblé. Ce module de commutation 100 réunit, par exemple, les interrupteurs 16 et 18 placés en miroir l'un au-dessus de l'autre.

La structure de l'interrupteur 16 est, par exemple, identique à celle de l'interrupteur 18 décrite en regard des figures 4 et 5. En particulier, l'interrupteur 16 comporte quatre commutateurs 110 à 113 respectivement identiques aux commutateurs 20 à 23 fixés sur un support 120, identique au support 90. Ici, les mêmes références que celles utilisées pour décrire le commutateur 20 sont utilisées pour désigner les éléments identiques des commutateurs 110 à 113. Le canal ouvert dans lequel sont logés les commutateurs 110 à 113 porte ici la référence 116.

En position assemblée, les substrats 60, respectivement des interrupteurs 16 et 18 se font face.

Une cale 130, en forme de parallélépipède horizontal, est logée entre les substrats 60, respectivement des interrupteurs 16 et 18 de manière à maintenir les commutateurs 110 à 113 à une distance prédéterminée des commutateurs 20 à 23.

Cette cale 130 comporte un logement pour chacun des commutateurs 20 à 23 et 110 à 113. De plus, la forme de cette cale 130 est adaptée pour venir sceller hermétiquement la surface ouverte des canaux 116 et 96.

A l'intérieur de cette cale 130 est ménagé un seul premier circuit 132 de circulation d'un liquide de refroidissement destiné à refroidir tous les transistors du module 100 par l'intermédiaire des substrats 60. A cet effet, deux évidements rectilignes horizontaux 133 et 134 de section transversale rectangulaire s'étendent à l'intérieur de la cale 130 parallèlement au plus grand côté de cette cale, et le long de la surface extérieure de chacun des substrats 60. L'extrémité gauche de ces évidements 133 et 134 est débouchante, tandis que les extrémités droites de ces mêmes évidements sont fluidiquement raccordées par l'intermédiaire d'un premier évidement semi circulaire 136. De préférence, l'épaisseur des évidements 133 et 134 est inférieure ou égale à un millimètre de manière à maximiser l'efficacité du transfert de chaleur par rapport au volume de liquide de refroidissement mis en oeuvre.

La cale 130 comporte également à son extrémité droite un second évidement semi circulaire 138 raccordant fluidiquement les extrémités de droite des canaux 96 et 116. Ainsi, un second circuit 140 de circulation du liquide de refroidissement propre à refroidir tous les transistors du module 100 par l'intermédiaire des substrats 50 est créé.

Les circuits 132 et 140 présentent chacun une section longitudinale en forme de "U".

L'extrémité droite de la cale 130 contenant les évidements 136 et 138 est soit venue de matière avec la cale 130 soit, par exemple, venue de matière avec l'un des supports 90 ou 120.

A l'intérieur du module 100, les premier et second circuits 132 et 140 sont fluidiquement indépendants l'un de l'autre.

Les extrémités de gauche du canal 96 et de l'évidement 133 sont raccordés fluidiquement par l'intermédiaire d'un raccord 141 en forme de Y à la sortie d'une même pompe 142.

De façon similaire, les extrémités de gauche du canal 116 et de l'évidement 134 sont raccordées fluidiquement par un raccord 144 en forme de Y à l'entrée de cette même pompe 142. Ainsi, une seule pompe permet de faire circuler le liquide de refroidissement dans les deux circuits 132 et 140.

Ici, la sortie de la pompe 142 est apte à propulser le liquide de refroidissement à l'intérieur des circuits 132 et 140, et l'entrée de la pompe 142 est apte à aspirer le liquide de refroidissement présent dans les circuits 132 et 140.

Le sens de circulation de ce liquide est représenté par des flèches sur la figure 7.

Le fonctionnement du module 100 va maintenant être décrit.

Lors du fonctionnement des interrupteurs, chaque transistor produit de la chaleur à cause des pertes par commutation mais aussi a cause de la conduction d'électricité. La partie la plus importante de la chaleur produite est transférée par l'intermédiaire du collecteur et du substrat 50 au radiateur 72. La présence de petit canaux fins formés par les espaces entre les ailettes 74 du radiateur 72 permet d'augmenter la surface de contact avec le liquide de refroidissement circulant dans le circuit 140. Le transfert de chaleur entre le radiateur 72 et le liquide de refroidissement se fait donc de façon plus efficace.

L'autre partie de la chaleur produite par les transistors est transférée par l'intermédiaire des substrats 60, directement au liquide de refroidissement circulant dans le circuit 132.

Ainsi, puisque les transistors sont refroidis par l'intermédiaire de leurs faces inférieure et supérieure, l'échauffement de chaque transistor est considérablement limité. Il est, dès lors, possible d'utiliser ces transistors pour commuter des courants bien supérieurs à la valeur nominale du courant pour lesquels ils sont prévus. Il est donc possible grâce à la présence de deux circuits de refroidissement, respectivement des faces inférieures et supérieures des transistors soit de fabriquer un module 100 de commutation, capable de commuter des courants de valeurs bien plus importantes avec le même nombre de transistors soit de réduire le nombre de transistors et donc la taille du module 100 pour commuter un courant identique.

Ici, le liquide de refroidissement utilisé est, par exemple, de l'eau. Toutefois, en variante, d'autres liquides de refroidissement peuvent être utilisés. Il est également possible de remplacer le liquide de refroidissement par un gaz, tel qu'un gaz inerte.

En variante, il est aussi possible de rendre complètement indépendants les circuits 132 et 140, c'est à dire de ne pas avoir de raccords fluidiques 141 et 144 aux extrémités de gauche des canaux 96 et 116 et respectivement des évidements 133 et 134. Même si une telle réalisation ne présente à priori pas d'avantages particuliers, il est néanmoins envisageable de faire circuler grâce à la pompe 142 un liquide de refroidissement dans le circuit 140, et de faire circuler grâce à une autre pompe un gaz inerte de refroidissement dans le circuit 132.

Ici, le module 100 décrit comporte un seul premier circuit 132 de refroidissement des substrats 60 et un seul second circuit de refroidissement des substrats 50 alimentés à partir d'une même pompe. Toutefois, en variante, le module de puissance comporte plusieurs premiers circuits de refroidissement des substrats 60 et plusieurs seconds circuits de refroidissement des substrats 50. A cet effet, par exemple, les canaux 96 et 116 et les évidements 133 et 134 sont débouchants à chacune de leur extrémité droite et gauche. Les extrémités débouchantes de gauche sont raccordées de façon similaire à ce qui a été décrit en regard de la figure 7 à une première pompe, tandis que les extrémités débouchantes de droite sont raccordées de façon analogue à une seconde pompe Dans cette variante, les canaux 96 et 116 forment deux premiers circuits indépendants l'un de l'autre, de circulation d'un fluide destiné à refroidir les substrats 50, respectivement des interrupteurs 16 et 18. Les évidements 133 et 134 forment deux seconds circuits indépendants de circulation d'un fluide destiné à refroidir les substrats 60, respectivement des interrupteurs 16 et 18.

Le module 100 a été décrit dans le cas particulier où les transistors sont des transistors IGBT. Toutefois, en variante, les transistors sont, par exemple, des transistors bi-polaires ou des transistors MOSFET ou encore remplacés par d'autres composants électroniques qu'il est nécessaire de refroidir de façon efficace.

Les interrupteurs ont été ici décrits dans le cas particulier où ils comportent quatre commutateurs. Toutefois, en variante, un interrupteur de puissance peut être formé de plus de quatre commutateurs ou de moins de quatre commutateurs, tel que, par exemple, d'un seul commutateur.

## Revendications

1. Module de commutation de puissance comportant :
- au moins un commutateur de puissance (110 à 113) au-dessus d'au moins un autre commutateur de puissance (20 à 23), chaque commutateur de puissance comportant deux parois respectivement supérieure et inférieure, ces deux parois étant aptes à être refroidies chacune par conduction thermique avec un fluide de refroidissement,
- deux supports (90) et (120) sur lesquels sont fixées respectivement les parois inférieures et supérieures (50) des commutateurs du dessous et du dessus
- des canaux fermés inférieurs (96) et supérieurs (116) ménagés respectivement dans les supports (90) et (120) configurés pour faire circuler un fluide de refroidissement le long respectivement des parois inférieures et supérieures (50) des commutateurs du dessous et du dessus,
**caractérisé en ce qu'**il comporte une cale (130) logée entre le ou les commutateurs (110 à 113) du dessus et le ou les commutateurs (20 à 23) du dessous de manière à maintenir entre eux une distance prédéterminée dans laquelle sont ménagés,
un évidement inférieur (133) le long et au dessus de la paroi supérieure (60) du ou de chaque commutateur du dessous ainsi qu'un évidement supérieur (134) le long et au dessous de la paroi inférieure (60) du ou de chaque commutateur du dessus pour refroidir ces parois (60) en faisant circuler un fluide de refroidissement dans chaque évidement inférieur (133) et supérieur (134).

2. Module selon la revendication 1, dans lequel lesdits évidements inférieur (133) et supérieur (134) possèdent deux extrémités raccordées entre elles pour former un seul circuit (132) de circulation de fluide de refroidissement.

3. Module selon la revendication 1 ou 2, dans lequel le ou chaque commutateur (20 à 23, 110 à 113) comporte un seul radiateur (72) thermiquement raccordé à l'une de ces parois inférieure ou supérieure, ce radiateur étant équipé d'ailettes (74) en contact direct avec le liquide de refroidissement circulant dans les canaux (96, 116) ou les évidements (133, 134).

4. Module selon la revendication 3, dans lequel seule la paroi supérieure (50) du ou de chaque commutateur (110 à 113) du dessus comporte un radiateur (72), et seule la paroi inférieure du ou de chaque commutateur (20 à 23) du dessous comporte un radiateur (72).

5. Module selon la revendication 3 ou 4, dans lequel les ailettes (74) des radiateurs sont parallèles à la direction principale de circulation du fluide de refroidissement.

6. Module selon l'une quelconque des revendications précédentes, dans lequel les canaux inférieur (96) et supérieur (116) sont raccordés l'un à l'autre pour former un seul circuit (140) de circulation de fluide de refroidissement le long de la paroi supérieure (50) du ou de chaque commutateur du dessus et le long de la paroi inférieure (50) du ou de chaque commutateur du dessous.

7. Module selon la revendication 2 ou 6, dans lequel le ou chaque circuit (132, 140) de circulation du fluide de refroidissement est raccordé à une même pompe (142) apte à faire circuler le fluide de refroidissement dans le ou chaque circuit de circulation.

8. Module selon l'une quelconque des revendications précédentes, dans lequel au moins les extrémités d'un évidement et d'un canal sont raccordées à une embouchure commune (141, 144) d'entrée ou de sortie d'un même fluide de refroidissement.

9. Module selon l'une quelconque des revendications précédentes, dans lequel le fluide de refroidissement est un liquide, tel que de l'eau.

10. Module selon l'une quelconque des revendications précédentes, dans lequel chaque commutateur comporte :
- plusieurs transistors (26 à 29), et
- des pistes électriques (62, 64) sur lesquelles l'émetteur et/ou la grille de chaque transistor est soudé, ces pistes étant réalisées sur une surface intérieure de la paroi (60) refroidie par le fluide de refroidissement qui circule dans l'évidement (133, 134).

11. Module selon la revendication 10, dans lequel chaque commutateur comporte en plus des pistes électriques (52) sur lesquelles le collecteur de chaque transistor (26 à 29) est soudé, ces pistes étant réalisées sur une surface intérieure de la paroi refroidie par le fluide de refroidissement qui circule dans un canal (96, 116).

12. Module selon la revendication 10 ou 11, dans lequel les transistors sont raccordés électriquement aux pistes électriques par l'intermédiaire de cylindres (80) de soudure fondus.

13. Module selon l'une quelconque des revendications précédentes, dans lequel ladite cale (130)est de forme sensiblement parallélépipédique et possède un logement pour chaque commutateur (110 à 113) et (20 à 23).

14. Module selon la revendication 13, dans lequel la forme de ladite cale (130) est adaptée pour venir sceller hermétiquement la surface ouverte des canaux inférieurs (96) et supérieurs (116).

15. Module selon la revendication 2 et la revendication 13 ou 14, dans lequel ledit seul circuit (132) de circulation de fluide de refroidissement est ménagé à l'intérieur de ladite cale (130), et dans lequel lesdits évidements inférieur (133) et supérieur (134) ont une section transversale rectangulaire et s'étendent à l'intérieur de la cale parallèlement à son plus grand côté.

16. Module selon l'une quelconque des revendications précédentes, dans lequel l'épaisseur des évidements inférieur (133) et supérieur (134) est inférieure ou égale à un millimètre.

17. Onduleur polyphasé dans lequel chaque phase comporte deux interrupteurs (16, 18) formés chacun d'au moins un commutateur (20 à 23, 110 à 113), **caractérisé en ce que** les deux interrupteurs (16,18) d'une même phase sont réalisés à l'aide d'un seul module de commutation de puissance conforme à l'une quelconque des revendications précédentes.

## Claims

1. A power switching module comprising:
- at least one power switch (110 to 113) above at least one other power switch (20 to 23), with each power switch comprising two upper and lower walls respectively, these two walls each being capable of being cooled by thermal conduction with a cooling liquid,
- two supports (90) and (120) on which the lower and upper walls (50) of the bottom and top switches are respectively fixed
- lower (96) and upper (116) closed channels arranged respectively in the supports (90) and (120) configured in order to cause a cooling liquid to circulate along the lower and upper walls (50) respectively of the upper and lower switches,
**characterised in that** it comprises a wedge (130) located between the upper switch(es) (20 to 23) and the lower switches (20 to 23) in order to maintain a predetermined distance between the latter in which are arranged,
a lower hollow (133) along and above the upper wall (60) of the bottom switch or each bottom switch in addition to an upper hollow (134) along and below the lower wall (60) of the upper switch or each upper switch in order to cool these walls (60) by causing a cooling liquid to circulate in each lower hollow (133) and upper hollow (134).

2. A module according to claim 1 in which the aforementioned lower hollow (133) and upper hollow (134) possess two ends connected to one another in order to form a single circuit (132) for circulation of cooling fluid.

3. A module according to claim 1 or 2, in which the switch or each switch (20 to 23, 110 to 113) comprises a single radiator (72) thermally connected to one of these lower or upper walls, with this radiator being equipped with vanes (74) in direct contact with the cooling liquid circulating in the channels (96, 116) or the hollows (133, 134).

4. A module according to claim 3, in which only the upper wall (50) of the upper switch or each upper switch (110 to 113) comprises a radiator (72) and only the lower wall of the lower switch or each lower switch (20 to 23) comprises a radiator (72).

5. A module according to claim 3 or 4, in which the vanes (74) of the radiators are parallel to the main direction of circulation of the cooling liquid.

6. A module according to any of the preceding claims, in which the lower channels (96) and upper channels (116) are connected to one another in order to form a single circuit (140) for circulation of cooling liquid along the upper wall (50) of the upper switch or each upper switch and along the lower wall (50) of the lower switch or each lower switch.

7. A module according to claim 2 or 6, in which the circuit or each circuit (132, 140) for circulation of the cooling liquid is connected to the same pump (140) capable of causing the cooling liquid to circulate in the circulation circuit or each circulation circuit.

8. A module according to any of the preceding claims, in which at least the ends of a hollow and a channel are connected to a common inlet or outlet opening (141, 144) of the same cooling liquid.

9. A module according to any of the preceding claims, in which the cooling fluid is a liquid, such as water.

10. A module according to any of the preceding claims, in which each switch comprises:
- several transistors (26 to 29) and
- electrical tracks (62, 64) to which the transmitter and/or grid of each transistor is soldered, with these tracks being created on an inside surface of the wall (60) cooled by a cooling liquid circulating in the hollow (133, 134).

11. A module according to claim 10, in which each switch comprises in addition to the electrical tracks (52) to which the collector of each transistor (26 to 29) is welded, these tracks being created on an inside surface of the wall cooled by the cooling liquid which circulates in a channel (96, 116).

12. A module according to claim 10 to 11, in which the transistors are electrically connected to the electric tracks by means of fused soldering cylinders (80).

13. A module according to any of the previous claims in which the aforementioned wedge (130) is of a roughly parallelepiped shape and possesses a recess for each switch (110 to 113) and (20 to 23).

14. A module according to claim 13, in which the shape of the aforementioned wedge (130) is adapted in order to hermetically seal the open surface of the inside channels (96) and upper channels (116).

15. A module according to claim 2 and claim 13 or 14, in which the aforementioned sole circuit (132) for circulation of cooling liquid is arranged inside the aforementioned wedge (130) and in which the aforementioned inner hollows (133) and upper hollows (134) have a rectangular transversal section and extend inside the wedge parallel to its longest side.

16. A module according to any of the preceding claims, in which the thickness of the inner hollows (133) and upper hollows (134) is less than or equal to one millimetre.

17. A polyphase inverter in which each phase comprises two switches (16, 18) each formed of at least one switch (20 to 23, 110 to 113) **characterised in that** the two switches (16, 18) of a same phase are created with the aid of a single power switching module in accordance with any of the preceding claims.

## Patentansprüche

1. Leistungsschaltermodul, das Folgendes aufweist:
- mindestens einen Leistungsschalter (110 bis 113) über mindestens einem weiteren Leistungsschalter (20 bis 23), wobei jeder Leistungsschalter eine obere und eine untere Wand aufweist, die jeweils durch Wärmeleitung mit einem Kühlfluid gekühlt werden können,
- zwei Träger (90) und (120), an denen die unteren beziehungsweise oberen Wände (50) der unteren und oberen Schalter befestigt werden,
- untere (96) und obere (116) geschlossene Kanäle, die in den Trägern (90) beziehungsweise (120) vorgesehen und so angeordnet sind, dass sie ein Kühlfluid an den unteren beziehungsweise oberen Wänden (50) der unteren und oberen Schalter entlang zirkulieren lassen,
**dadurch gekennzeichnet, dass** es einen Block (130) zwischen dem oder den oberen Schaltern (110 bis 113) und dem oder den unteren Schaltern (20 bis 23) aufweist, sodass diese in einem vorher festgelegten Abstand voneinander gehalten werden,
und weiter eine untere Aussparung (133) entlang und über der oberen Wand (60) des oder jedes unteren Schalters sowie eine obere Aussparung (134) entlang und unter der unteren Wand (60) des oder jedes oberen Schalters, um die Wände (60) durch Zirkulation eines Kühlfluids in jeder unteren Aussparung (133) und oberen Aussparung (134) zu kühlen.

2. Modul nach Anspruch 1, bei dem die untere Aussparung (133) und die obere Aussparung (134) zwei miteinander verbundene Enden aufweisen, um einen einzigen Umlaufkreis (132) für das Kühlfluid zu bilden.

3. Modul nach Anspruch 1 oder 2, bei dem der oder jeder Schalter (20 bis 23, 110 bis 113) einen einzigen Kühler (72) aufweist, der wärmetechnisch mit der unteren oder oberen Wand verbunden ist, wobei der Kühler mit Rippen (74) versehen ist, die in direktem Kontakt mit dem Kühlfluid in den Kanälen (96, 116) oder den Aussparungen (133, 134) stehen.

4. Modul nach Anspruch 3, bei dem nur die obere Wand (50) des oder jedes oberen Schalters (110 bis 113) einen Kühler (72) aufweist und nur die untere Wand des oder jedes unteren Schalters (20 bis 23) einen Kühler (72) aufweist.

5. Modul nach Anspruch 3 oder 4, bei dem die Rippen (74) der Kühleren parallel zur Hauptumlaufrichtung des Kühlfluids verlaufen.

6. Modul nach einem der vorhergehenden Ansprüche, bei dem der untere Kanal (96) und der obere Kanal (116) miteinander verbunden sind, um einen einzigen Umlaufkreis (140) für das Kühlfluid entlang der oberen Wand (50) des oder jedes oberen Schalters und entlang der unteren Wand (50) des oder jedes unteren Schalters zu bilden.

7. Modul nach Anspruch 2 oder 6, bei dem der oder jeder Umlaufkreis (132, 140) für das Kühlfluid mit einer gleichen Pumpe (142) verbunden ist, die das Kühlfluid in dem oder in jedem Umlaufkreis in Umlauf bringt.

8. Modul nach einem der vorhergehenden Ansprüche, bei dem mindestens die Enden einer Aussparung und eines Kanals mit einer gemeinsamen Einlass- oder Auslassöffnung (141, 144) für ein gleiches Kühlfluid verbunden sind.

9. Modul nach einem der vorhergehenden Ansprüche, bei dem das Kühlfluid eine Flüssigkeit wie beispielsweise Wasser ist.

10. Modul nach einem der vorhergehenden Ansprüche, bei dem jeder Schalter Folgendes aufweist:
- mehrere Transistoren (26 bis 29) und
- elektrische Bahnen (62, 64), an die der Emitter und/oder das Gate jedes Transistors angelötet ist, wobei die Bahnen an einer Innenfläche der Wand (60) ausgebildet sind, die von dem in der Aussparung (133, 134) zirkulierenden Kühlfluid gekühlt wird.

11. Modul nach Anspruch 10, bei dem jeder Schalter außerdem elektrische Bahnen (52) aufweist, an die der Kollektor jedes Transistors (26 bis 29) angelötet ist, wobei die Bahnen an einer Innenfläche der Wand ausgebildet sind, die von dem in einem Kanal (96, 116) zirkulierenden Kühlfluid gekühlt wird.

12. Modul nach Anspruch 10 oder 11, bei dem die Transistoren elektrisch über geschmolzene Lotzylinder (80) mit den elektrischen Bahnen verbunden sind.

13. Modul nach einem der vorhergehenden Ansprüche, bei dem der Block (130) im Wesentlichen parallelepipedförmig ist und eine Aufnahme für jeden Schalter (110 bis 113) und (20 bis 23) besitzt.

14. Modul nach Anspruch 13, bei dem die Form des Blocks (130) geeignet ist, die offene Fläche der unteren Kanäle (96) und der oberen Kanäle (116) hermetisch zu verschließen.

15. Modul nach Anspruch 2 und Anspruch 13 oder 14, bei dem der einzige Umlaufkreis (132) für Kühlfluid innerhalb des Blocks (130) vorgesehen ist und bei dem die untere Aussparung (133) und die obere Aussparung (134) einen rechteckigen Querschnitt aufweisen und sich innerhalb des Blocks parallel zu seiner größten Seite erstrecken.

16. Modul nach einem der vorhergehenden Ansprüche, bei dem die Dicke der unteren Aussparung (133) und der oberen Aussparung (134) kleiner oder gleich einem Millimeter ist.

17. Mehrphasen-Wechselrichter, bei dem jede Phase zwei Trennschalter (16, 18) aufweist, die jeweils aus mindestens einem Schalter (20 bis 23, 110 bis 113) gebildet sind, **dadurch gekennzeichnet, dass** die beiden Trennschalter (16, 18) einer gleichen Phase mithilfe eines einzigen Leistungsschaltermoduls nach einem der vorhergehenden Ansprüche hergestellt werden.
